Europäisches Patentamt

European Patent Office

Office européen des brevets

(19)

(11)  **EP 0 602 892 B1**

(12)  **EUROPEAN PATENT SPECIFICATION**

(45) Date of publication and mention
of the grant of the patent:
**10.06.1998   Bulletin 1998/24**

(51) Int Cl.⁶: **H02M 1/088**, H02M 1/06

(21) Application number: **93309891.5**

(22) Date of filing: **08.12.1993**

(54) **Semiconductor valve**

Halbleiterstromrichterventil

Soupape électrique d'un redresseur à semi-conducteurs

(84) Designated Contracting States:
**DE FR GB SE**

(30) Priority:  **17.12.1992   JP 336898/92**

(43) Date of publication of application:
**22.06.1994   Bulletin 1994/25**

(73) Proprietor: **KABUSHIKI KAISHA TOSHIBA**
**Kawasaki-shi, Kanagawa-ken 210 (JP)**

(72) Inventor: **Seki, Nagataka,**
**c/o Intellectual Property Division**
**Minato-ku, Tokyo (JP)**

(74) Representative: **BATCHELLOR, KIRK & CO.**
**2 Pear Tree Court**
**Farringdon Road**
**London EC1R 0DS (GB)**

(56) References cited:
**EP-A- 0 141 624**          **DD-A- 298 719**
**US-A- 4 888 676**

## Description

BACKGROUND OF THE INVENTION

Field of the Invention

This invention relates to a semiconductor valve in which high-speed, high-voltage switching valve devices (hereinbelow called "semiconductor devices") are connected in series.

Description of the Related Art

In thyristor valves employed in D.C. power transmission, frequency conversion or reactive power regulation etc., the voltage rating of each thyristor is at most 6 kv. Usually therefore a number of thyristors on the order of several tens to one hundred are connected in series. In this case, there is a risk of failure due to overvoltage unless a large number of thyristors execute identical operation. Generally, therefore, the thyristors are selectively employed. For example, in the "Points to be noted in connection with series connection" in Section 2.5 of "Power Electronics" by Kohji Imai, published in 1977 by Denki Shoin, it is indicated that, in order to suppress the variation in the sharing voltages on turnoff to the prescribed value, it is necessary to keep the variation in the thyristor recovery charges within a certain range.

As an example for switching valve devices, in Section 5.4 of "Turn-off thyristors" by Nagataka Seki, et al., published in 1983 by Denki Shoin, it is indicated, in order to suppress the variation in sharing voltages on turn-off of series-connected GTOs to the prescribed value, it is necessary to control the variation in the storage times of GTOs.

Fig. 3 is a view given in explanation of the waveforms of the anode current I, the gate current Ig and the anode voltage V, on GTO turn-off. Taking the variation in the storage times of two GTOs as $\Delta ts$, the cut-off current as I, and the variation in the electric charges as $\Delta Q1$ when two GTOs are connected in series, these may be expressed approximately by the following equation.

$$\Delta Q1 = \Delta ts \cdot I$$

$\Delta Q1$ is equal to the variation in the electric charges of the snubber capacitors, so if the variation in the sharing voltages is subsequently taken to be $\Delta V$, then, taking the capacitance of the snubber capacitor as C, we have:

$$\Delta V = \Delta Q1/C = \Delta ts \cdot I/C \qquad (1)$$

In a GTO, current turn-off is effected by shifting current to a snubber capacitor. The capacitance of the snubber capacitor is therefore closely linked to the cut-off current. For example in the case of a 3000 A device, cut-off of 3000 A is guaranteed under test conditions of snubber capacitor capacitance of 6 μF. In the case of the series connection, the larger capacitance is selected from the capacitor capacitance found from equation (1) and the capacitor capacitance found from the cut-off current.

However, large snubber capacitor capacitance implies large loss. Specifically, since energy of $(1/2) CE^2$ is lost in a single switching process (where E is the D. C. voltage), if a power converter is operated in the range of some MW at a switching frequency of 500 Hz, the loss generated by the snubber capacitors alone amounts to 3 - 4% of power conversion capacity. Efforts are therefore continuing to make the capacitance of the snubber capacitor as small as possible.

One way of decreasing snubber capacitance is to improve the GTO itself. As is well known, a GTO consists of an integration of small GTO unit cells of a few hundred μ in size. The capacitance of the snubber capacitor can be further reduced by further fine-processing the GTO unit cells. This is set out for example in the Toshiba Review, Vol. 47, No. 1, page 29, Fig.7 (January 1992).

Additionally, various types of new high-speed semiconductor devices called for example MCTs (MOS controlled thyristor) or SITHs (static induction thyristor) are currently being studied. If these are implemented, the selection criterion of capacitor capacitance defined in equation (1) is insufficient. This will be explained below.

Fine-processing applied to the new high-speed semiconductor devices will make the snubber capacitance small, and transistor type semiconductor devices exemplified by IGBTs may not necessarily require a snubber capacitor. However, in the case of both the new high-speed semiconductor devices and IGBTs, when employing higher voltages, it may be anticipated that the current flowing in the tail time tl shown in Fig. 3 (this is called the tail current) will be predominant. The tail current is produced by the discharge of the carriers stored in the n base; the thickness of the n base increases in proportion to the withstand voltage so stored carrier i.e. the tail current increases as the withstand voltage of the semiconductor device is increased. In contrast, the capacitance of the snubber capacitor decreases with fineprocessing. Thus, even when device operation is to be speeded up, the extent of reduction in tail time is slight, though the turn-off time is greatly reduced. The turn-off time in the case of a GTO means the time until the junction between the p base and n emitter recovers and is represented in the drawing by tgq. Consequently, as regards the ratio of the charge Q1 of turn-off time tgq and charge Q2 of the tail time, this latter will be relatively increased by miniaturization. As a result, the selection of capacitor capacitance based on equation (1) will be inappropriate.

The reader is referred to DD-A-298 719 and US-A-4 888 676.

As described above, the problem is to suppress the variation in sharing voltages on series connection that is produced by increasing the speed of a semiconductor device.

SUMMARY OF THE INVENTION

Accordingly, one object of this invention is to provide a semiconductor valve in which the variation in the sharing voltages on turn-off of the semiconductor devices can be suppressed to a prescribed value without increasing the snubber capacitor capacitance.

These and other objects of this invention can be achieved by providing a semiconductor valve including a plurality of series-connected semiconductors devices and a plurality of capacitors. Each of the capacitors is connected in parallel to one of the semiconductor devices, respectively. Each of the semiconductor devices is a switching valve device having a pair of main electrodes and at least one control electrode. The semiconductor devices are such that a first variation in quantities with respect to tail charges on turn-off of the semiconductor devices is within a first prescribed value.

BRIEF DESCRIPTION OF THE DRAWINGS

A more complete appreciation of the invention and many of the attendant advantages thereof will be readily obtained as the same becomes better understood by reference to the following detailed description when considered in connection with the accompanying drawings, wherein:

Fig. 1 is a circuit diagram showing a semiconductor valve according to an embodiment of this invention;

Fig. 2 is an operational waveform diagram on turn-off of a semiconductor valve shown in Fig 1; and

Fig. 3 is a diagram given in explanation of symbols and waveforms on turn-off of GTOs.

DETAILED DESCRIPTION OF THE PREFERRED EMBODIMENTS

Referring now to the drawings, wherein like reference numerals designate identical or corresponding parts throughout the several views, the embodiments of this invention will be described below.

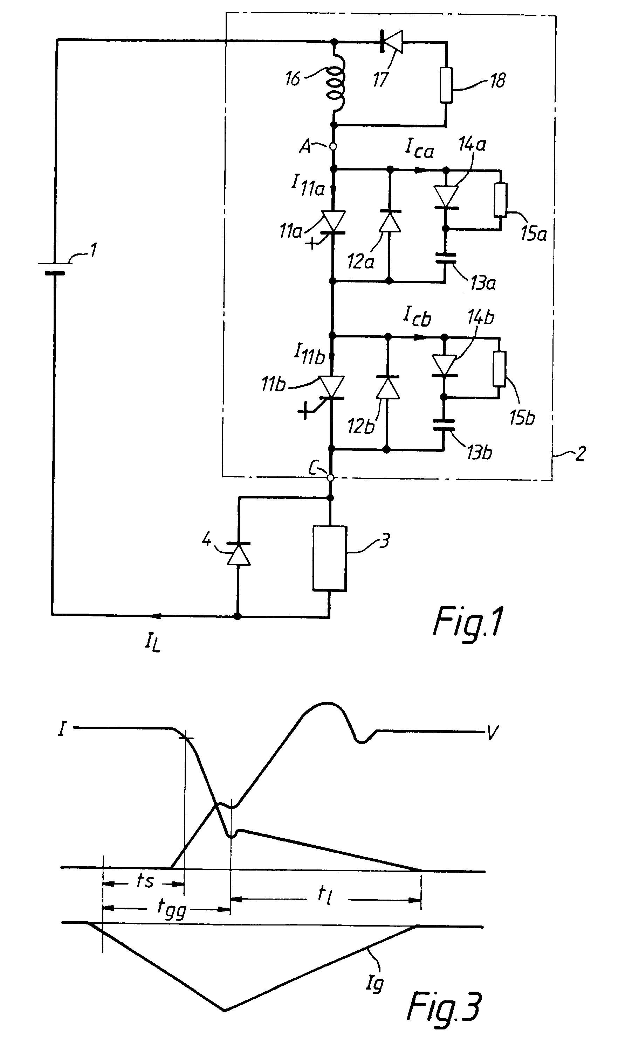

Fig. 1 is a circuit diagram showing a semiconductor valve according to an embodiment of this invention. In Fig. 1, 1 is a D.C. power source, 2 is a semiconductor valve, 3 is a load and 4 is a free-wheeling diode. The internal layout of semiconductor valve 2 is constituted by two sets of series connected semiconductor devices and their associated components, distinguished by suffixes a and b. 11 is a high-speed semiconductor device, abbreviated as HSSD in this specification, having a self-extinguishing function but the symbols are the same as for a GTO. 12 is a diode connected in anti-parallel with the HSSD 11. 13 is a snubber capacitor. 14 is a snubber diode. 15 is a snubber resistor. 16 is a valve reactor. 17 is a diode. 18 is a resistor that dissipates the energy of valve reactor 16.

The layout of the semiconductor valve shown in Fig. 1 is a circuit that is conventionally employed. However, in a circuit of this type, this specification, relates how to select a semiconductor device for suppressing variation in sharing voltages on turn-off a semiconductor device, without increasing snubber capacitor capacitance.

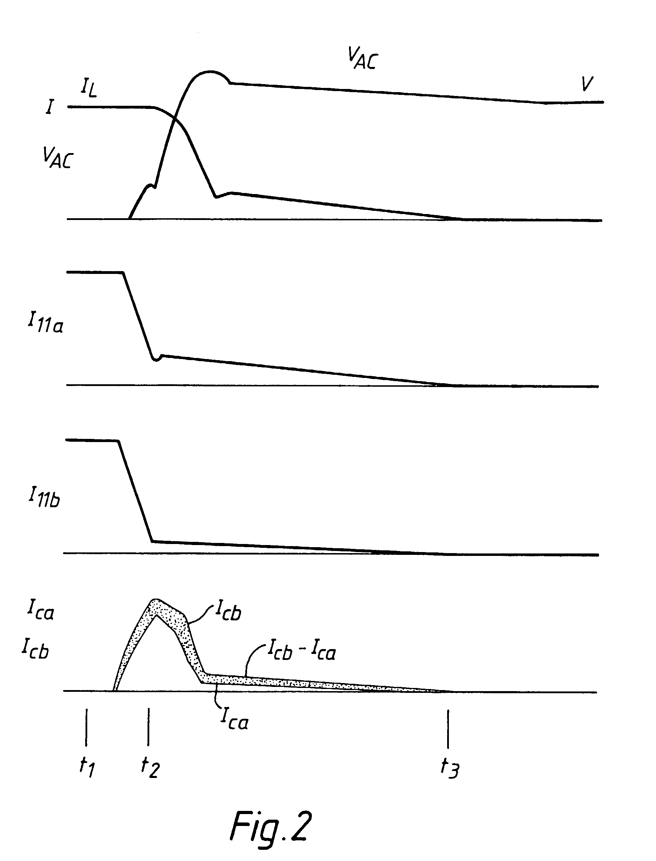

First of all, the operation of this circuit will be described using Fig. 1 and Fig. 2. Let us consider the process whereby HSSDs 11a and 11b are turned off when a current IL is flowing from D.C. power source through valve reactor 16 and HSSDs 11a and 11b to load 3. When an OFF signal is applied to HSSD 11 at time tl, the current IL flowing through HSSD 11 is divided into a current I11 flowing the HSSD 11 itself and a current Ic flowing through the series circuit of snubber diode 14 and snubber capacitor 13. The currents I11 and Ic are also distinguished by suffixes a and b, and currents I11a, I11b, Ica and Icb are shown in Figs. 1 and 2. This current Ic charges snubber capacitor 13. The voltage VAC between A and C shown in Fig. 1 is equal to the sum of the voltages of the two snubber capacitors 13a, 13b. When it tries to exceed power source voltage V, diode 4 conducts so that the circuit of load 3 and diode 4 is closed, allowing current IL to continue to flow. Some of the current flowing through valve reactor 16 is branched to the circuit consisting of diode 17 and resistor 18, while the rest continues to charge up snubber capacitor 13.

When

$$VAC - V = R \cdot IL$$

(where R is the resistance of resistor 18) is reached, all of the current IL of valve reactor 16 has shifted to the closed circuit of diode 17 and resistor 18 and charging of snubber capacitor 13 is completed. In practice, due to the effect of stray inductance, not shown in Fig. 1, snubber capacitor 13 is charged up slightly more, but a discussion of this will be omitted as going into more detail than is relevant to the explanation of this invention.

In the waveforms in Fig. 2, the factor that affects the sharing voltage of HSSD 11 is the ratio of the current flowing in HSSD 11 and the current flowing in snubber capacitor 13 from the time t1 up until the time t3. In Fig. 2, t1 is the time when an OFF signal is applied to HSSD 11, t2 is the time when the turn-off time of HSSD 11 passes from the time tl, and t3 is the time when the tail time of HSSD 11 passes from the time t2. In general, the capacitor voltage is expressed by Q/C, where Q is the charge and is the time-integrated value of the current flowing in the capacitor, and C is the capacitor capacitance. If the capacitance C of capacitors 13a and 13b is equal, the variation in the voltages arises from the variations in the magnitudes and times of the capacitor currents Ica and Icb. Since the current I flowing through the series connection is the same for both circuits of suffixes a and b, the cause of variation in the capacitor current Ica and Icb lies in the variation in the currents flowing through the interiors of the two HSSDs; these currents are determined by the charges in the interiors of the HSSDs. As explained earlier, thanks to fine-processing, the turn-off time of the HSSD (time between t1 and t2 in Fig. 2, tgq in Fig. 3) is short, so the degree of its variation in small. However, the tail time is not shortened by the miniaturization, so this comes to give rise to the variation in the currents. For example, if the variation in the tail currents of HSSDs of the 1000 A class is assumed to be 20 A, and the tail times are equal at 50 as, the variation $\Delta Q$ in charges Q is 20 A·(50/2) = 500 microcoulomb. If the snubber capacitance is assumed to be 0.2 $\mu$F, the variation $\Delta V$ in the voltages is, $\Delta V = 500/0.2 = 2500$ V. For a 5000 V device the allowed value of the variation $\Delta V$ is at most 500 V, so a snubber capacitor capacitance on the order of 1 $\mu$F must be chosen; this makes it impossible to raise the switching frequency. In this invention, therefore, the variations in the tail charges (this term is defined here for convenience as meaning the charge which is discharged as tail current during the tail time) is taken as the device selection criterion in series connection. For example, in the case described above, if the variation in the tail currents is taken as no more than 4 A, by a similar calculation the snubber capacitor capacitance is 0.2 $\mu$F and the variation $\Delta V$ is 500 V.

Using this selection criterion, sharing voltage can easily be contained within an allowed value without increasing snubber capacitor capacitance by selecting the semiconductor devices such that the variation in tail charge on turn-off of the semiconductor devices is within a prescribed value, so high-speed ON/OFF control of the HSSD can be achieved.

As a quantity with respect to the tail charge, a tail current or a tail time may be used independently for selection criteria of series-connected semiconductor devices. It is also possible to take the ON voltage as a selection criterion. Specifically, the ON voltage is correlated with the number of carriers within the base region; the voltage drops as more carriers accumulate. Selection of devices for series connection can therefore be performed taking as criterion the ON voltage when a certain reference current, gate and temperature conditions are given (In the case of transistor operation this is called the saturation voltage. As used herein, the term "ON voltage" includes this.)

Also, although in the semiconductor valve of Fig. 1 the number of semiconductor devices connected in series was 2, this number can have any value from 2 upwards. In this case, as the variation in the tail charges on turn-off of a plurality of semiconductor devices, a difference between a maximum value and a minimum value of the tail charge on turn-off of the semiconductor devices may be used.

Furthermore, in this invention the situation regarding presence or absence of anti-parallel-connected diode 12 and the type of snubber circuit is not restricted to that shown in Fig. 1. The circuit to which the semiconductor valve is applied is not restricted to that of Fig. 1. Furthermore, GTOs or IGBTs which have been further improved are to be included as HSSDs.

As described above, according to this invention, in performing series connection of HSSDs, the variation in the sharing voltages on turn-off can be suppressed to a prescribed value without increasing the snubber capacitor capacitance by taking at least one of the quantity with respect to the tail charge including the tail charge, the tail current, the tail time and the ON voltage as selection criterion. As a result, there are the considerable industrial benefits that the increase of loss and deterioration of controllability resulting from increase in capacitor capacitance can be prevented and that productivity can be raised.

Obviously, numerous modifications and variations of the present invention are possible in light of the above teachings. It is therefore to be understood that within the scope of the appended claims, the invention may be practiced otherwise than as specifically described herein.

## Claims

1. A semiconductor valve, comprising:

   a plurality of series-connected semiconductor devices; and
   a plurality of capacitors, each being connected in parallel to one of said semiconductor devices, respectively;
   each of said semiconductor devices including a switching device having a pair of main electrodes and at least one control electrode;

   characterised in that

   said semiconductor devices are such that a variation in quantities with respect to tail charges on turn-off of said semiconductor devices is within a prescribed range of values.

2. The semiconductor valve according to Claim 1, wherein:

   said prescribed value is decided such that a variation in sharing voltages is below a prescribed value; and
   each of said sharing voltages is a voltage between said pair of main electrodes of one of said semiconductor devices, respectively.

**3.** The semiconductor valve according to Claim 1, wherein:

said quantity with respect to said tail charge includes said tail charge on turn-off of said semiconductor device itself.

**4.** The semiconductor valve according to Claim 1, wherein:

said quantity with respect to said tail charge includes a tail current on turn-off of said semiconductor device.

**5.** The semiconductor valve according to Claim 1, wherein:

said quantity with respect to said tail charge includes a tail time on turn-off of said semiconductor device.

**6.** The semiconductor valve according to Claim 1, wherein:

said quantity with respect to said tail charge includes an ON voltage of said semiconductor device.

**7.** The semiconductor valve according to Claim 1, wherein:

said variation is a difference between a maximum value and a minimum value of said quantities with respect to said tail charge on turn-off of said semiconductor devices.

**8.** The semiconductor value according to Claim 1 wherein:

said semiconductor device includes a high speed switching device.

**9.** A method of manufacturing a semiconductor valve, having a plurality of series-connected semiconductor devices; and

a plurality of capacitors, each being connected in parallel to one of said semiconductor devices, respectively;
each of said semiconductor devices including a switching device having a pair of main electrodes and at least one control electrode;

characterised in that

said method includes the step of selecting said semiconductor devices such that a variation in tail charges on turn-off of said semiconductor devices is less than a prescribed value.

**Patentansprüche**

**1.** Halbleiterventil, mit:

einer Anzahl von in Serie geschalteten Halbleitereinrichtungen; und
einer Anzahl von Kondensatoren, von denen jeder parallel zu jeweils einer der Halbleitereinrichtungen geschaltet ist;
wobei jede der Halbleitereinrichtungen eine Schalteinrichtung mit einem Paar Hauptelektroden und zumindest einer Steuerelektrode enthält;

**dadurch gekennzeichnet**, daß

die Halbleitereinrichtungen so sind, daß eine Veränderung von Mengen betreffend Schwanzladungen (tail charges) beim Ausschalten der Halbleitereinrichtungen innerhalb eines vorbestimmten Bereiches von Werten liegt.

**2.** Halbleiterventil nach Anspruch 1, bei dem:

der vorbestimmte Wert so bestimmt ist, daß eine Veränderung der Teilspannungen (sharing voltages) unterhalb eines vorbestimmten Wertes liegt; und
jede der Teilspannungen eine Spannung zwischen dem Paar von Hauptelektroden von jeweils einer der Halbleitereinrichtungen ist.

**3.** Halbleiterventil nach Anspruch 1, bei dem:

die Menge betreffend die Schwanzladung die Schwanzladung beim Ausschalten der Halbleitereinrichtung selbst umfaßt.

**4.** Halbleiterventil nach Anspruch 1, bei dem:

die Menge betreffend die Schwanzladung einen Schwanzstrom (tail current) beim Ausschalten der Halbleitereinrichtung umfaßt.

**5.** Halbleiterventil nach Anspruch 1, bei dem:

die Menge betreffend die Schwanzladung eine Schwanzzeit (tail time) beim Ausschalten der Halbleitereinrichtung umfaßt.

**6.** Halbleiterventil nach Anspruch 1, bei dem:

die Menge betreffend die Schwanzladung eine EIN-Spannung der Halbleitereinrichtung umfaßt.

7. Halbleiterventil nach Anspruch 1, bei dem:

die Veränderung eine Differenz zwischen einem Maximalwert und einem Minimalwert der Mengen betreffend die Schwanzladung beim Ausschalten der Halbleitereinrichtungen ist.

8. Halbleiterventil nach Anspruch 1, bei dem:

die Halbleitereinrichtung eine Hochgeschwindigkeits-Schalteinrichtung umfaßt.

9. Verfahren zur Herstellung eines Halbleiterventils, das eine Anzahl von in Serie geschalteten Halbleitereinrichtungen; und

eine Anzahl von Kondensatoren aufweist, von denen jeder parallel zu jeweils einer der Halbleitereinrichtungen geschaltet ist;
wobei jede der Halbleitereinrichtungen eine Schalteinrichtung mit einem Paar Hauptelektroden und zumindest einer Steuerelektrode enthält;

**dadurch gekennzeichnet**, daß

das Verfahren den Schritt des Auswählens der Halbleitereinrichtungen umfaßt, so daß eine Veränderung betreffend Schwanzladungen beim Ausschalten der Halbleitereinrichtungen kleiner ist als ein vorbestimmter Wert.

## Revendications

1. Soupape à semi-conducteur comprenant :

une pluralité de dispositifs à semi-conducteur connectés en série ; et
une pluralité de condensateurs, chacun étant respectivement connecté en parallèle avec l'un desdits dispositifs à semi-conducteur ;
chacun desdits dispositifs à semi-conducteur comportant un dispositif de commutation ayant une paire d'électrodes principales et au moins une électrode de commande ;

caractérisé en ce que

lesdits dispositifs à semi-conducteur sont tels qu'une variation en quantités en ce qui concerne des charges de traînée lors du passage à l'état non-actif desdits dispositifs à semi-conducteur se trouve à l'intérieur d'une plage de valeurs prescrite.

2. Soupape à semi-conducteur selon la revendication 1, dans laquelle :

ladite valeur prescrite est décidée de façon qu'une variation des tensions partagées se trouve au-dessous d'une valeur prescrite ; et chacune desdites tensions partagées est une tension respectivement entre lesdites deux électrodes principales de l'un desdits dispositifs à semi-conducteur.

3. Soupape à semi-conducteur selon la revendication 1, dans laquelle :

ladite quantité concernant ladite charge de traînée comporte ladite charge de traînée lors du passage à l'état non-actif dudit dispositif à semi-conducteur lui-même.

4. Soupape à semi-conducteur selon la revendication 1, dans laquelle :

ladite quantité concernant ladite charge de traînée comporte un courant de traînée lors du passage à l'état non-actif dudit dispositif à semi-conducteur.

5. Soupape à semi-conducteur selon la revendication 1, dans laquelle :

ladite quantité concernant ladite charge de traînée comporte un temps de traînée lors du passage à l'état non-actif dudit dispositif à semi-conducteur.

6. Soupape à semi-conducteur selon la revendication 1, dans laquelle :

ladite quantité concernant ladite charge de traînée comporte une tension MARCHE dudit dispositif à semi-conducteur.

7. Soupape à semi-conducteur selon la revendication 1, dans laquelle :

ladite variation est une différence entre une valeur maximale et une valeur minimale desdites quantités concernant ladite charge de traînée lors du passage à l'état non-actif desdits dispositifs à semi-conducteur.

8. Soupape à semi-conducteur selon la revendication 1, dans laquelle :

ledit dispositif à semi-conducteur comporte un dispositif de commutation à grande vitesse.

9. Procédé de fabrication d'une soupape à semi-conducteur, comportant une pluralité de dispositifs à semi-conducteur connectés en série ; et

une pluralité de condensateurs, chacun étant respectivement connecté en parallèle avec l'un desdits dispositifs à semi-conducteur ; chacun desdits dispositifs à semi-conducteur comportant un dispositif de commutation ayant une paire d'électrodes principales et au moins une électrode de commande ;

caractérisé en ce que

ledit procédé comporte l'étape consistant à choisir lesdits dispositifs à semi-conducteur de façon qu'une variation de charges de traînée lors du passage à l'état non-actif desdits dispositifs à semi-conducteur soit inférieure à une valeur prescrite.

*Fig.1*

*Fig.3*

*Fig.2*